Europäisches Patentamt

**European Patent Office**

Office européen des brevets

(11) Veröffentlichungsnummer: **0 100 772**
**B1**

(12) **EUROPÄISCHE PATENTSCHRIFT**

(45) Veröffentlichungstag der Patentschrift:
**19.11.87**

(51) Int. Cl.⁴: **G 11 C 17/00**

(21) Anmeldenummer: **82107132.1**

(22) Anmeldetag: **06.08.82**

(54) **Elektrisch programmierbare Speichermatrix.**

(43) Veröffentlichungstag der Anmeldung:
**22.02.84 Patentblatt 84/8**

(45) Bekanntmachung des Hinweises auf die Patenterteilung:
**19.11.87 Patentblatt 87/47**

(84) Benannte Vertragsstaaten:
**DE FR NL**

(56) Entgegenhaltungen:
**EP - A - 0 055 594**
**EP - A - 0 088 815**
**DE - A - 3 103 807**
**US - A - 4 266 283**
**US - A - 4 317 110**

**PATENTS ABSTRACTS OF JAPAN, Band 5, Nr. 1, (P-43)**
**(673), 8. Januar 1981**
**PATENTS ABSTRACTS OF JAPAN, Band 2, Nr. 108,**
**Seite 5793 E 78, 1978**
**COMPUTER DESIGN, Band 20, Nr. 4, April 1981, Seite**
**224, Winchester, Mass., USA, "Controller chip for 2816**
**EEPROM with support kit"**

(73) Patentinhaber: **Deutsche ITT Industries GmbH, Hans-Bunte-Strasse 19 Postfach 840, D-7800 Freiburg (DE)**

(84) Benannte Vertragsstaaten: **DE**

(73) Patentinhaber: **ITT INDUSTRIES INC., 320 Park Avenue, New York, NY 10022 (US)**

(84) Benannte Vertragsstaaten: **FR NL**

(72) Erfinder: **Giebel, Burkhard, Dipl.-Ing., Berliner Strasse 25/2, D-7809 Denzlingen (DE)**

(74) Vertreter: **Morstadt, Volker, Dipl.-Ing., c/o Deutsche ITT Industries GmbH Patent/Lizenzabteilung Postfach 840 Hans-Bunte-Strasse 19, D-7800 Freiburg/Brsg. (DE)**

## Beschreibung

Aus der Zeitschrift «Electronics» vom 28. Februar 1980, Seiten 113 bis 117, ist eine elektrisch programmierbare Speichermatrix mit in m Spalten und n Zeilen angeordneten programmierbaren Speicherzellen bekannt. Jede der Speicherzellen enthält eine Source-Drain-Reihenschaltung eines Speichertransistors mit einem Auswahltransistor. Bei der bekannten Speichermatrix wird ein Speichertransistor mit potentialmässig schwebender Elektrode (Floating Gate) verwendet, welche durch Tunneln von Elektronen durch eine Dünnoxidschicht zwischen dem Substrat und der potentialmässig schwebenden Elektrode als Speichermedium umgeladen werden kann.

Aus «1980 IEEE International Solid-State Circuits Conference. Digest of Technical Papers», Seiten 152 und 153, ist eine Speichermatrix mit derartigen Speicherzellen bekannt, welche in Speichergruppen zu je b Speicherzellen angeordnet sind. Die Speichergruppen wiederum sind in w Blöcken zu b Spalten und in n Zeilen organisiert. Die Gates der w · b = m Auswahltransistoren jeder Zeile sind über eine gemeinsame Zeilenwahlleitung mit je einem von n Ausgängen eines Zeilendekoders verbunden. Die Steuergates der b Speichertransistoren jeder Gruppe sind dagegen an einer gemeinsamen Programmierleitung angeschlossen und über die Source-Drain-Strecke eines Gruppenwahltransistors blockweise mit einer gemeinsamen Blockleitung verbunden. Das Gate des Gruppenwahltransistors liegt an der entsprechenden Zeilenwahlleitung. Somit wird eine blockweise Anwahl der Gruppen jedes Blockes möglich.

Bei der bekannten elektrisch löschbaren Speichermatrix sind ferner die Speicherzellen spaltenweise mit je einer durchlaufenden ersten und zweiten Bitleitung kontaktiert und die Blockleitung mit einer Blocksignalquelle über die Source-Drain-Strecke eines Blockwahltransistors, dessen Gate an einem von w Ausgängen eines Blockdekoders angeschlossen ist, je Block verbunden. Die Ausgänge des Blockdekoders sind ausserdem mit den Gates von b Spaltenwahltransistoren verbunden, deren Source-Drain-Strecken wiederum jeweils eine der zweiten Bitleitungen jedes Blockes mit einer der Datenleitungen verbinden.

Bei der bekannten Speichermatrix sind die ersten Bitleitungen entsprechend der gewählten Funktion «Löschen» niederohmig oder beim «Schreiben» hochohmig auf ein Grundpotential legbar. Andererseits sind die zweiten Bitleitungen beim «Löschen» auf das Grundpotential, beim «Schreiben» auf ein dazu ausreichend hohes Potential und beim «Lesen» auf das Lesepotential legbar. Die Gates der Auswahltransistoren sind zum «Löschen» und zum «Schreiben» an das Programmierpotential legbar. Die Erfindung bezieht sich auf eine Speichermatrix, bei der mindestens einer der genannten Dekoder (Blockdekoder, Zeilendekoder) vorhanden ist.

Die Erfindung betrifft eine elektrisch programmierbare Speichermatrix gemäss dem Oberbegriff des Anspruchs 1, wie sie für die benannten Vertragsstaaten aufgrund der nicht vorveröffentlichten EP-A-0 088 815 zum Stand der Technik nach Art 54(3) EPÜ gehört.

Eine derartige Speichermatrix kann in Geräten verwendet werden, bei der ein Teil der Speicherzellen zwar bestimmungsgemäss vom Benutzer umprogrammiert werden kann, ein anderer Fall, aber für die Speicherung von werkseigenen Abgleichdaten verwendet wird, so dass ein Adressbereich verriegelbar sein sollte.

Es ist daher Aufgabe der Erfindung, eine Speichermatrix gemäss dem Oberbegriff des Anspruchs 1 durch einen einfach realisierbaren Peripherieschaltungsteil zu erweitern, der es ermöglicht, dass ein festgelegter Anteil der Speicherzellen nur dann umprogrammiert werden kann, wenn neben den notwendigen Adress- und Funktionssignalen ein weiteres Eingangssignal vorhanden ist, so dass ein Adressbereich verriegelbar ist. Der Lesebetrieb soll von diesen Massnahmen jedoch nicht betroffen sein.

Der Erfindung liegt der Grundgedanke zugrunde, mindestens einen der Dekoder aufzuteilen und durch eine Zusatzschaltung derart zu ergänzen, dass in der Zuleitung zur Programmierleitung der zu schützenden Speicherzelle bzw. Speicherzellen mindestens ein Transistor, nämlich mindestens der zugehörige Gruppenwahltransistor oder der zugehörige Blockwahltransistor, und in der Zuleitung zum Injektor der zu schützenden Speicherzelle bzw. zu den Injektoren der zu schützenden Speicherzellen ebenfalls mindestens ein Transistor, nämlich mindestens der zugehörige Auswahltransistor oder der zugehörige Spaltenwahltransistor, liegt, wobei die Gatespannung dieser Transistoren derartig begrenzt wird (beispielsweise kleiner als 8V ist), dass ein für das Umprogrammieren erforderliches hohes Potential weder an der Programmierleitung noch am Injektor auftreten kann.

Die oben genannte Aufgabe wird erfindungsgemäss bei der elektrisch programmierbaren Speichermatrix gemäss dem Oberbegriff des Anspruchs 1 durch die im kennzeichnenden Teil dieses Anspruchs genannte Ausbildung gelöst.

Aus der EP-A-0 055 594 ist zwar bei einer ähnlichen elektrisch programmierbaren Speichermatrix ohne Blockdekoder bekannt, einen Spaltendekoderteil mit einem Funktionssignaleingang vorzusehen, der mit dem Ausgang einer zwei Eingänge aufweisenden Zusatzschaltung verbunden ist, an deren erstem Eingang wie auch an den Funktionssignaleingängen der übrigen Zeilendekoderteile das Funktionssignal direkt anliegt. Der erste Eingang der Zusatzschaltung ist aber unterschiedlich zur Erfindung mit dem Adresseneingang des betroffenen Zeilendekoderteils verbunden, um während der Prüfzeit die angewählten Speicherzellen der zugehörigen Matrixspalte auf einem oberen Potential zu halten. Dies ist aber keine Lösung der der Erfindung zugrundeliegenden Aufgabe.

Bei einer gattungsfremden magnetischen Speicheranordnung, wie sie in «Patents Abstracts of Japan» Band 5, Nr. 201 (19. Dezember 1981), Seite (P. 94) (873) beschrieben ist, ist zwar die Vernichtung von Informationen auf das Zusatzsignal eines «read-only/write enable»-Schalters verhinderbar. Bei dieser Anordnung wird aber das Schreibsignal aufgrund des Adressensignals einer Speicherplatte blockiert und nicht irgendwelche Dekoder abgewandelt. Der oben genannte Grundgedanke der Erfindung ist bei dieser bekannten Speicheranordnung nicht anwendbar.

Die Erfindung wird im folgenden anhand der Zeichnung erläutert,

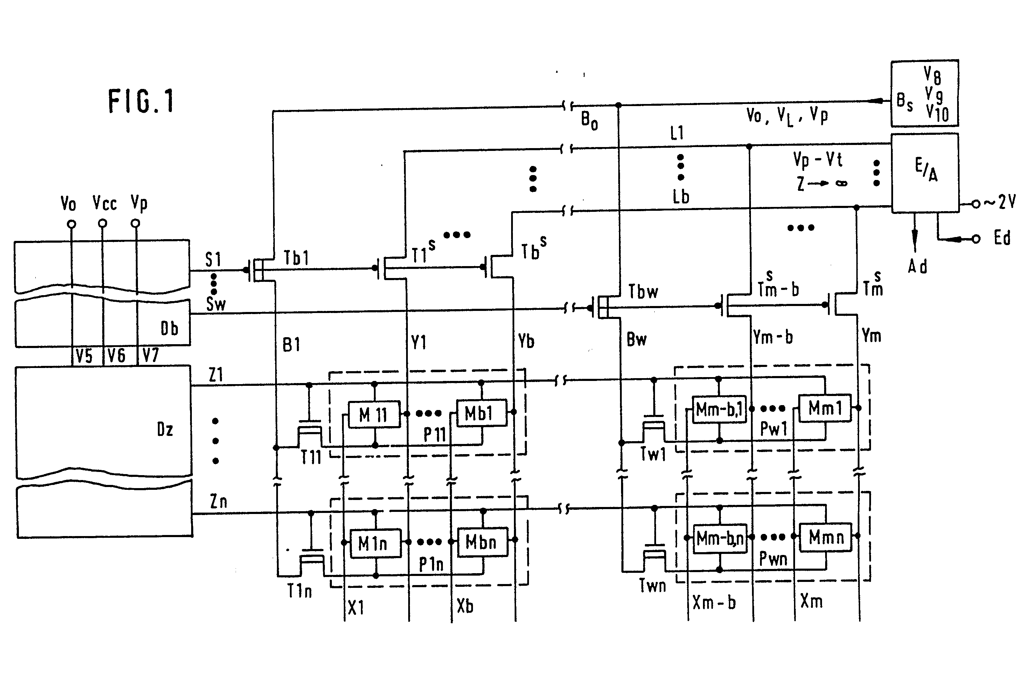

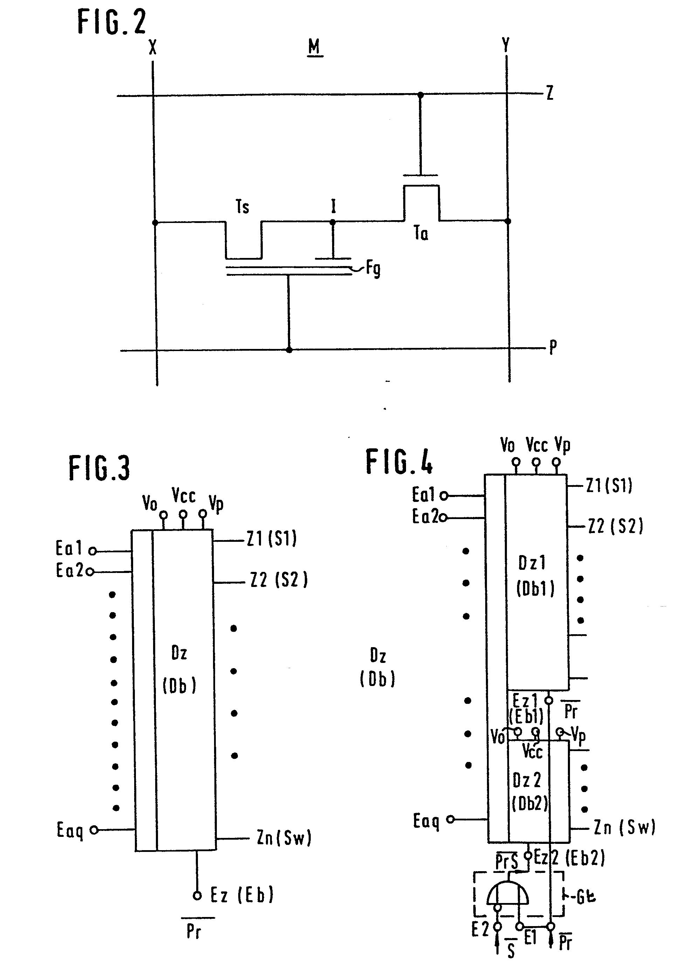

deren Fig. 1 das Blockschaltbild einer elektrisch programmierbaren Speichermatrix entsprechend dem bekannten Stand der Technik betrifft,

deren Fig. 2 das Prinzipschaltbild einer Speicherzelle veranschaulicht, wie sie in der Speichermatrix gemäss der Fig. 1 verwendet werden kann,

deren Fig. 3 die Blockdarstellung des Zeilendekoders Dz bzw. des Blockdekoders Db der Fig. 1 enthält und

deren Fig. 4 die Blockdarstellung des Zeilendekoders bzw. des Blockdekoders der elektrisch programmierbaren Speichermatrix nach der Erfindung zeigt.

Die elektrisch programmierbare Speichermatrix gemäss der Fig. 1 enthält die m · n Speicherzellen M11 bis Mmn, welche entsprechend dem einleitend genannten Stand der Technik gemäss der in Fig. 2 dargestellten Speicherzelle M ausgebildet werden können. Bei dieser Speicherzelle mit der potentialmässig schwebenden Gateelektrode Fg, wie sie ausführlich in der eingangs genannten Literaturstelle aus der Zeitschrift «Electronics» vom 28. Februar 1980 beschrieben wird, ist ein in beiden Richtungen zu der elektrisch schwebenden Elektrode Fg wirksamer Tunnelinjektor I vorgesehen, der einerseits über die Source-Drain-Strecke des Speichertransistors Ts mit einer ersten Bitleitung X und andererseits über die Source-Drain-Strecke eines Auswahltransistors Ta mit einer zweiten Bitleitung Y verbunden ist. Das Steuergate des Speichertransistors Ts ist einerseits an der Programmierleitung P angeschlossen, während das Gate des Auswahltransistors Ta mit einer Zeilenwahlleitung Z verbunden ist.

Bei der elektrisch löschbaren Speichermatrix gemäss der Fig. 1 sind ferner die Speicherzellen M11 bis Mmn in w Blöcken zu je b Spalten angeordnet, so dass Speichergruppen mit je b elektrisch umprogrammierbaren Speicherzellen vorhanden sind. Die Steuergates der Speichertransistoren jeder Gruppe liegen an je einer gemeinsamen Programmierleitung der Programmierleitungen P11 bis Pwn. Jede dieser Programmierleitungen ist über die Source-Drain-Strecke eines der Gruppenwahltransistoren T11 bis Twn mit einer der w Blockleitungen verbunden, an welche wahlweise über die Source-Drain-Strecke eines der w Blockwahltransistoren Tb1 bis Tbw entweder das Grundpotential Vo, das Lesepotential $V_L$ oder das Programmierpotential Vp anlegbar ist. Die Gates der Blockwahltransistoren Tb1 bis Tbw und die Gates der jeweils zugeordneten Spaltenwahltransistoren T1s bis Tms sind an jeweils einem der w Ausgänge des Blockdekoders Db angeschlossen. Die Bitleitungen, beispielsweise Y1 bis Yb, sind über je eine Source-Drain-Strecke eines der b Spaltenwahltransistoren und über eine der Datenleitungen L1 bis Lb mit einem der b Ausgänge der Datenschaltung E/A verbunden, über welche wortweise die Daten eingegeben oder gelesen werden können.

Unter «Löschen» wird bei der in Betracht gezogenen Speicherzelle mit einem Speichertransistor, der eine potentialmässig schwebende Elektrode aufweist, der Vorgang verstanden, bei dem Ladungen vom Leitungstyp der Diffusionszonen in das als Elektrode mit schwebenden Potential ausgebildete Speichermedium gelangen. Bei einem MNOS-Speichertransistor ist dieses Speichermedium durch die Grenzfläche zwischen der Oxidschicht und der Nitridschicht gegeben, aus der die Gateisolatorschicht besteht. Bei einem N-Kanal-Speichertransistor gelangen also beim «Löschen» Elektronen ins Speichermedium und werden beim «Schreiben» aus diesem wieder entfernt.

Die Adresse der umzuprogrammierenden Speicherzelle wird digital in den Blockdekoder Db, in den Zeilendekoder Dz und in die Datenschaltung E/A eingegeben. Durch die in die Dekoder eingegebenen digitalen Adressignale wird die umzuprogrammierende Speicherzelle bestimmt, welche sich am Kreuzungspunkt der über die Adresse angewählten ersten Bitleitungen X, zweiten Bitleitungen Y, Programierleitungen P und Zeilenwahlleitung Z liegt. Nichtangewählte Zellen werden nicht umprogrammiert.

Da zum Verständnis der Erfindung lediglich die Funktionen «Löschen angewählt», «Löschen nicht angewählt», «Schreiben angewählt» und «Schreiben nicht angewählt» von Interesse sind, sind diese daher in der im folgenden angegebenen Funktionstabelle mit den Potentialen für die Zellen/Ansteuerleitungen angegeben. Wird unter M(1) eine angewählte Speicherzelle und unter M(o) eine nichtangewählte Speicherzelle verstanden, so werden bei der Speichermatrix der Fig. 1 den oben genannten Leitungen die in der folgenden Funktionstabelle angegebenen Potentiale aufgeprägt:

| | Löschen | | Schreiben | |
| | M(1) | M(0) | M(1) | M(0) |
|---|---|---|---|---|
| Z | Vp | Vo | Vp | Vo |
| S | Vp | Vo | Vp | Vo |
| P | Vp | /Vtd/ oder Vo | Vo | Vo |
| X | Vo | Vo | Vo(hochohmig) | Vo |
| Y | Vo | Vo | Vp-Vte | Vo(hochohmig) |

Darin bedeutet Vte die Einsatzspannung eines in der Fig. 1 nicht gezeigten Anreicherungs-Feldeffekttransistors, der in der Y-Leitung liegt und Vtd die Einsatzspannung der Gruppenwahltransistoren T11 bis Twn.

Aus der obigen Funktionstabelle ist ersichtlich, dass beim Löschen beispielsweise der Speicherzelle M11 das positive Programmierpotential Vp über die weit aufgesteuerten Transistoren Tb1 und T11 auf das Steuergate gelangt, während die zweite Bitleitung Y1 am Bezugspotential Vo bzw. Masse liegt. Es werden daher Elektronen aus dem Injektor in das Floating-Gate Fg injiziert. Beim Schreiben dagegen gelangt das in der Nähe des Programmierpotentials Vp liegende positive Potential Vp–Vt über die zweite Bitleitung Y1, welche mittels eines in ihrem Verlauf gegen Masse liegenden Transistors gegen Masse gesperrt ist, über den weit aufgesteuerten (Vp!) Auswahltransistor Ta an den Injektor I, so dass aus dem Floating-Gate Elektronen in den Injektor injiziert werden.

Die Erfindung schafft nun die Möglichkeit, das Umprogrammieren eines bestimmten Anteils der Speicherzellen zu blockieren, indem die Potentiale auf den Leitungen, über die ein zum Umprogrammieren der Speicherzelle bzw. Speicherzellen erforderliches Potential an den Injektor bzw. die Injektoren oder an das Steuergate bzw. die Steuergates gelangen könnten, begrenzt ist, wie im folgenden erläutert wird.

Der in Fig. 1 blockweise dargestellte Zellendekoder Dz herkömmlichen Aufbaus weist die Adresseingänge Ea1 bis Eaq auf, über die in Form eines Digitalwortes die Adresse der angewählten Speicherzelle bzw. der angewählten Speicherzellen M(1) eingegeben wird. Über Funktionssignaleingänge, von denen lediglich der Programmiersignaleingang Ez angegeben ist, werden die wahlweise einzugebenden Funktionssignale «Schreiben», «Lesen»...eingegeben. Der Zeilendekoder Dz weist schliesslich zur Spannungsversorgung drei Anschlüsse auf, an die die zum Betrieb der Speichermatrix erforderlichen Spannungen bzw. Potentiale angelegt werden. Diese sind das Grundpotential Vo, welches im allgemeinen dem Massepotential entspricht, das Potential der Versorgungsspannung Vcc und das Potential Vp der Programmierspannungsquelle, welches sowohl beim «Schreiben» als auch beim «Löschen» auf die Zeilenwahlleitung der zu programmierenden Speicherzellen gelegt wird. Wird also an den Funktionssignaleingang Ez zum «Programmieren» die logische «Null» gelegt, so erscheint auf der angewählten Zeilenwahlleitung das Programmierpotential Vp, ansonsten nur Vcc.

Der Blockdekoder Db, dessen Ausgänge S1 bis Sw sowohl die Gates der den Ausgängen zugeordneten Blockwahltransistoren Tb1 bis Tbw als auch blockweise die Gates der b Spaltenwahltransistoren T1$^s$ bis Tm$^s$ ansteuert, ist in gleicher Weise wie der Blockdekoder Db ausgestattet, wie durch die Klammer gesetzten Symbole in der Fig. 3 veranschaulicht wird.

In der Fig. 4 ist blockschaltmässig der in der elektrisch programmierbaren Speichermatrix nach der Erfindung verwendete Zellendekoder Dz dem in der Fig. 3 dargestellten von herkömmlichen Aufbau gegenübergestellt. Gleiches gilt für den Blockdekoder Db, wie durch die in Klammer gesetzten Symbole angedeutet ist. Der Zeilendekoder Dz bzw. der Blockdekoder Db, wie er bei der elektrisch programmierbaren Speichermatrix nach der Erfindung verwendet wird, ist in einen ersten Dekoderteil Dz1 (Db1) und in einen zweiten Dekoderteil Dz2 (Db2) aufgeteilt. Während am Funktionssignaleingang Ez1 (Eb1) des ersten Dekoderteils Dz1 (Db1) das Funktionssignal $\overline{Pr}$ direkt angelegt wird, liegt am Funktionssignaleingang Eb2 (Ez2) des zweiten Dekoderteils Dz2 (Db2) der Ausgang der Gatterschaltung Gt, welche die zwei Eingänge E1 und E2 aufweist. Entsprechend der Erfindung ist diese Gatterschaltung in an sich dem Fachmann bekannter Weise derart auszulegen, dass das Ausgangssignal nur dann auf dem der Funktion «Programmieren» entsprechenden Wert liegt, wenn sowohl der erste Eingang E1, auf dem die Funktion «Programmieren» entsprechenden Wert liegt, als auch der zweite Eingang auf demjenigen Wert liegt, der ein Programmieren des vom zweiten Dekoderteil Dz2 (Db2) angesteuerten Speichermatrix-Teils zulässt.

Entsprechend der in der Fig. 4 angegebenen bevorzugten Ausführungsform ist die Gatterschaltung ein OR-Gatter Gt, dessen erster Eingang E1 mit dem Funktionssignaleingang Ez1 (Eb1) des ersten Dekoderteils Dz1 verbunden ist und dessen zweiter Eingang E2 das dort angelegte Eingangssignal $\overline{S}$ invertiert. Damit wird erreicht, dass bei Verbinden des zweiten Eingangs E2 mit dem Bezugspotential bzw. Masse Vo eine ausgewählte Zeile des zweiten Dekoderteils Dz2 (Db2) nur ein Potential von Vcc erreicht und somit eine Programmierung im geschützten Matrix-Teil ausgeschlossen ist.

Eine derartige Gatterschaltung, wie sie in der Fig. 4 angegeben ist, ist besonders günstig bei der Fertigung von Geräten mit einer elektrisch löschbaren Speichermatrix, bei der im vom zweiten Dekoderteil Dz2 (Db2) angesteuerten Matrixteil Abgleichsdaten gespeichert werden. Eine Blokkierung des zweiten Dekoderteils Dz2 (Db2) kann nämlich auf einfache Weise durch Verbinden des zweiten Eingangs E2 mit Masse erfolgen, was beispielsweise durch einen nicht ohne weiteres zugänglichen Schalter oder auch durch einfaches Verlöten mit einem Masseanschluss erfolgen kann. Im allgemeinen ist es völlig ausreichend, entweder den Zeilendekoder Dz oder den Blockdekoder Db entsprechend der Erfindung zu teilen und auszubilden, um ein Programmieren nach einem Programmiervorgang, der beispielsweise zum Abgleich eines Fernsehempfängers erfolgen könnte, zu blockieren. Es liegt aber durchaus im Rahmen der Erfindung, auch beide Dekoder aufzuteilen und auszubilden. Die Erfindung ist anwendbar auf Speichermatrizen mit jeder denkbaren Zeilenzahl n und Spaltenzahl m, natürlich auf Speichermatrizen, deren Speicherzellen nicht blockweise zusammengefasst worden sind, oder auch Speichermatrizen mit nur einer Zeile oder auch nur einer Spalte.

**Patentansprüche**

1. Elektrisch programmierbare Speichermatrix mit in m Spalten und n Zeilen angeordneten programmierbaren Speicherzellen, die entsprechend einer der wählbaren Funktionen «Schreiben» und «Löschen» programmierbar und der Funktion «Lesen» elektrisch lesbar sind und die aus je einer Source-Drain-Reihenschaltung eines Auswahltransistors (Ta) mit einem Speichertransistor (Ts) bestehen, der mit einer potentialmässig schwebenden Gateelektrode (Fg) und einem in beiden Richtungen zu der schwebenden Gateelektrode wirksamen Injektor (I) versehen ist, wobei das Steuergate (G) des Speichertransistors an einer Programmierleitung (P) liegt, und wobei

– die Reihenschaltungen spaltenweise einerseits mit einer von m ersten Bitleitungen (X1...Xm), die entsprechend der gewählten Funktion «Löschen» niederohmig oder beim «Schreiben» hochohmig auf ein Grundpotential (Vo) legbar ist, und andererseits mit einer von m zweiten Bitleitungen (Y1...Ym) verbunden sind, die beim «Löschen» auf das Grundpotential (Vo), beim «Schreiben» auf ein dazu ausreichend hohes Potential (Vp–Vt) und beim «Lesen» auf das Lesepotential ($V_L$) legbar sind, und ferner die Gates der Auswahltransistoren (Ta) zum «Löschen» und zum «Schreiben» an das Programmierpotential (Vp) legbar sind, und wobei

– die n Gates der Auswahltransistoren (Ta) einer Zeile über eine Zeilenwahlleitung (Z) von n Zeilenwahlleitungen (Z1...Zn) an einem von n Ausgängen eines Zeilendekoders (Dz) mit einem zu seiner Aktivierung dienenden Funktionssignaleingang (Ez) liegen, an den ein binäres Funktionssignal ($\overline{Pr}$) anlegbar ist, so dass im inaktiven Zustand an den Injektoren (I) der Speicherzellen der angewählten Zeile ein für das Umprogrammieren erforderliches Programmierpotential (Vp) nicht auftreten kann, und oder

– die Steuergates der Speichertransistoren zeilenweise in Gruppen mit b = m/w (w = ganze Zahl) Zellen an je einer gemeinsamen Programmierleitung (P11...Pwn) liegen, welche über die Source-Drain-Strecke je eines Gruppenwahltransistors (T11...Twn) mit einer von w Blockleitungen (B1...Bw) verbunden sind, an welche wahlweise über die Source-Drain-Strecke eines von w Blocksignaltransistoren (Tb1...Tbw), deren Gates an je einem der w Ausgänge eines Blockdekoders (Db) mit einem zu seiner Aktivierung dienenden Funktionssignaleingang (Eb) angeschlossen sind, entweder das Grundpotential (Vo) oder das Lesepotential ($V_L$) oder das Programmierpotential (Vp) bei der Aktivierung des Blockdekoders (Db) anlegbar ist, und die einzelnen Ausgänge des Blockdekoders (Db) mit den Gates derjenigen von m Spaltenwahltransistoren (T1s...Tms) verbunden sind, über deren Source-Drain-Strecken die zweiten Bitleitungen (Y1...Yb, Ym–b...Ym, etc.) der betroffenen Gruppe an eines der gewählten Potentiale gelegt werden, dadurch gekennzeichnet,

– dass mindestens einer der Dekoder (Dz; Db) einen ersten Dekoderteil (Dz1; Db1) mit einem Funktionssignaleingang (Ez1; Eb1) aufweist, an den das Funktionssignal ($\overline{Pr}$) direkt angelegt wird, und einen zweiten Dekoderteil (Dz2; Db2) enthält, der ebenfalls einen Funktionssignaleingang (Ez2, Eb2) aufweist, der jedoch mit dem Ausgang einer zwei Eingänge (E1, E2) aufweisenden Gatterschaltung (Gt) verbunden ist, deren Ausgangssignal nur dann auf dem der Funktion «Programmieren» entsprechenden Wert liegt, wenn der erste Eingang (E1) ebenfalls auf dem der Funktion «Programmieren» entsprechenden Wert liegt und der zweite Eingang (E2) auf demjenigen Wert liegt, der ein Programmieren des zweiten Dekoderteils (Dz2; Db2) zulässt, so dass bei Anlegen des Funktionssignals ($\overline{Pr}$) nur auf den Leitungen des ersten Dekoderteils (Dz1; Db1) bzw. auf den Leitungen der ersten Dekoderteile (Dz1, Db1) das Programmierpotential (Vp) erscheinen kann.

2. Elektrisch programmierbare Speichermatrix nach Anspruch 1, dadurch gekennzeichnet,

– dass die Gatterschaltung (Gt) ein OR-Gatter ist, dessen erster Eingang (E1) mit dem Funktionssignaleingang (Ez1; Eb1) des ersten Dekoderteils (Dz1, Db1) verbunden ist und dessen zweiter Eingang (E2) das dort angelegte Eingangssignal (S) invertiert, so dass beim Verbinden des zweiten Eingangs (E2) mit Masse bzw. dem Bezugspotential (Vo) ein Programmieren des zweiten Dekoderteils (Dz2; Db2) ausgeschlossen ist.

**Claims**

1. Electrically programmable memory matrix comprising programmable memory cells arranged in m columns and n rows, which are programmable in accordance with one of the selectable functions "write" and "erase", and electrically readable in accordance with the function "read", and which each consist of a source-drain series arrangement of a select transistor (Ta) with a memory transistor (Ts) which is provided with a floating gate electrode (Fg) and with an injector (I) operating in both directions with respect to the floating gate electrode, with the control gate (G) of the memory transistor being applied to a programming line (P), and with

– said series arrangements on the one hand, in a columnwise manner, with one of m first bit lines (X1....Xm), capable of being applied to a ground potential (Vo) either in a low-ohmic manner in accordance with the selected function "erase" or else in a high-ohmic manner in accordance with the selected function "write" and, on the other hand, of being connected to one of m second bit lines (Y1....Ym) and which, in the "erase" function, are capable of being applied to said ground potential (Vo), in the "write" function to a potential (Vp–Vt) which is sufficiently high in relation thereto and, in the "read" function, to the read potential ($V_L$), and, moreover, with the gates of said select transistors (Ta) capable of being applied to the programming potential (Vp) for both the "erase" and the "write" functions, and with

– the n gates of said select transistors (Ta) of one row, via one row-select line (Z) of n row-select lines (Z1....Zn), capable of being applied to one of n outputs of a row decoder (Dz) with a function-signal input (Ez) serving the activation thereof, to which a binary function signal (Pr) is capable of being applied so that, in the inactive state, a programming potential (Vp) which is necessary for the re-programming, is prevented from appearing at the injector (I) of the memory cells of the respective selected row, and/or with

— the control gates of said memory transistors lying row-wisely in groups of b = m/w (w = whole number or integer) cells each to one common programming line (P11...Pwn) which, via the source-drain line of each time one group-select transistor (T11...Twn), are connected to one of w block lines (B1...Bw) to which, optionally, via the source-drain line of one of w block-signal transistors (Tb1...Tbw) whose gates are respectively connected at one of the w outputs of a block decoder (Db) to one function-signal input (Eb) serving the activation thereof, either said ground potential (Vo) or said read potential (V_L) or said programming potential (Vp) is capable of being applied upon activation of said block decoder (Db), and with the individual outputs of said block decoder (Db) being connected to the gates of those particular ones of m column-select transistors (T1s...Tms) via whose source-drain lines the second bit lines (Y1...Yb, Ym–b...Ym, etc.) of the respectively involved group are applied to one of the selected potentials, characterized in

— that at least one of said decoders (Dz; Db) comprises a first decoder part (Dz1; Db1) with a function-signal input (Ez1; Eb1) to which the function signal (P̄r̄) is applied directly, and a second decoder part (Dz2; Db2) likewise with a function-signal input (Ez2; Eb2) which, however, is connected to the output of a gate circuit (Gt) having two inputs (E1, E2), with the output signal thereof only then being of the value corresponding to the "programming" function when the first input (E1) is likewise of the value corresponding to the "programming" function, and when the second input (E2) shows to be of that particular value which permits a programming of said second decoder part (Dz2; Db2) so that, upon application of the function signal (P̄r̄), said programming potential (Vp) can appear only on the lines of said first decoder part (Dz1; Db1) or on those of said first decoder parts (Dz1; Db1) respectively.

2. An electrically programmable memory matrix as claimed in claim 1, characterized in

— that said gate circuit (Gt) is an OR gate whose first input (E1) is connected to the function signal input (Ez1; Eb1) of the first decoder part (Dz1, Db1) and whose second input (E2) inverts the input signal (S̄) as applied thereto, so that when the second input (E2) is connected to ground or to the reference potential (Vo), a programming of the second decoder part (Dz2; Db2) is excluded.

**Revendications**

1. Matrice de mémoire électriquement programmable comprenant des cellules de mémoire disposées selon m colonnes et n rangées, qui sont programmables dans l'une des fonctions «écriture» et «effacement» pouvant être sélectionnées et peuvent être électriquement lues dans une fonction «lecture», et qui consistent chacune en un agencement en série source-drain d'un transistor de sélection (Ta) et d'un transistor de mémoire (Ts) comprenant une électrode de grille (Fg) à potentiel flottant et un injecteur (I) agissant dans les deux sens sur l'électrode de grille flottante associée, la grille de commande (G) du transistor de mémoire étant connectée à une ligne de programmation (P), dans lequel:

— les agencements en série, par colonne, d'une part, peuvent être connectés au potentiel de la masse (Vo) par l'un de m premiers conducteurs de bit (X1...,Xm), soit par une faible résistance, lorsque la fonction «lecture» est sélectionnée, soit par une résistance forte, dans le cas de la fonction «écriture» et, d'autre part, peuvent être connectés, par l'un de m seconds conducteurs de bit (Y1...,Ym), soit au potentiel de la masse dans le cas de la fonction «effacement», soit à un potentiel suffisamment haut (Vp–Vt) dans le cas de la fonction «écriture», ou au potentiel de lecture (V_L) dans le cas de la fonction «lecture», les grilles des transistors de sélection (Ta) pouvant en outre être connectées au potentiel de programmation (Vp) dans les fonctions «effacement» et «écriture», et

— les n grilles de transistors de sélection (Ta) d'une rangée sont connectées, par l'intermédiaire d'un fil de sélection de rangée (Z) parmi n fils de sélection de rangée (Z1...,Zn) à l'une des n sorties d'un décodeur de rangée (Dz) dont une entrée de signal de fonction (Ez) servant à l'activer peut recevoir un signal de fonction binaire (P̄r̄), de sorte qu'à l'état non activé, aucun potentiel de programmation nécessaire pour la programmation ne peut atteindre les injecteurs (I) des cellules de mémoire de la rangée sélectionnée, et/ou

— les électrodes de commande des transistors de mémoire sont connectées, dans les rangées, par groupes de b = m/w (w étant un nombre entier) respectivement, à un fil commun de programmation (P11...,Pwn), lequel, par le trajet source-drain d'un transistor de sélection de groupe correspondant (T11...,Twn) est connecté à l'un de w fils de bloc (B1...,Bw) sur lequel est sélectivement appliqué, lorsque le décodeur de bloc (Db) est activé, par le trajet source-drain de w transistors de signal de bloc (Tb1...,Tbw) dont les grilles sont connectées chacune à une des w sorties d'un décodeur de bloc (Db) comportant une entrée de signal de fonction (Eb) servant à l'activer, soit au potentiel de la masse (Vo), soit au potentiel de lecture (V_L) ou au potentiel de programmation (Vp), les sorties individuelles du décodeur de bloc (Db) étant connectées aux grilles de ceux de m transistors de sélection de colonne (T1s...,Tms) par lesquels les trajets source-drain des seconds fils de bit (Y1...,Yb, Ym–b...,Ym, etc.) des groupes respectifs sont connectés à l'un des potentiels pouvant être sélectionnés, caractérisé en ce que,

— l'un au moins des décodeurs (Dz; Db) est subdivisé en au moins un premier décodeur partiel (Dz1; Db1) ayant une entrée de signal de fonction à laquelle le signal de fonction ($\overline{Pr}$) est directement appliqué et en un second décodeur partiel (Dz2; Db2) ayant aussi une entrée de signal de fonction, laquelle est connectée à la sortie d'un circuit de porte (Gt) ayant deux entrées (E1, E2) et dont le signal de sortie est au niveau correspondant à la fonction «programmation» seulement lorsque la première entrée (E1) est elle aussi au niveau correspondant à la fonction «programmation» et que la seconde entrée (E2) est au niveau particulier qui permet une programmation du second décodeur partiel (Dz2; Db2), de sorte que l'application du signal de fonction ($\overline{Pr}$) ne peut faire apparaître le potentiel de programmation (Vp) que sur les fils de premier décodeur partiel (Dz1; Db1) ou, respectivement, sur les fils du second décodeur partiel (Dz2; Db2).

2. Matrice de mémoire électriquement programmable conforme à la revendication 1, caractérisée en ce que:

— ledit circuit de porte est une porte OU dont la première entrée (E1) est connectée à l'entrée de signal de fonction (Ez1; Eb1) du premier décodeur partiel (Dz1; Db1) et dont la seconde entrée (E2) inverse le signal d'entrée ($\overline{S}$) qui lui est appliqué, de sorte que lorsque la seconde entrée (E2) est connectée à la masse, ou au potentiel de référence (Vo), une programmation du second décodeur partiel (Dz2; Db2) est impossible.

FIG.1

0 100 772

9

# FIG.2

# FIG.3

# FIG.4